# EUROPEAN PATENT APPLICATION

(11) **EP 4 592 937 A1**
(43) Date of publication of application: **30.07.2025**
(21) Application number: 22959636.6
(22) Date of filing: 25.11.2022
(51) Int. Cl.: G06Q 50/10, G06Q 10/083, G06Q 30/00, B60L 53/66, B60L 58/12

(54) **ELECTRONIC DEVICE, SERVER, AND OPERATING METHOD FOR PROVIDING USER GUIDE FOR BATTERY EVALUATION**

(30) Priority: 19.09.2022 KR 20220118198
(71) Applicant: LG Energy Solution, Ltd., Seoul 07335 (KR)
(72) Inventor: JUNG, Boo Soon, Daejeon 34122 (KR); YOON, Hye Jeong, Daejeon 34122 (KR); LEE, Jun Hyok, Daejeon 34122 (KR); LEE, Hyun Jun, Daejeon 34122 (KR); CHOI, Min Sook, Daejeon 34122 (KR); JANG, Moon Hee, Daejeon 34122 (KR)
(74) Representative: Goddar, Heinz J.
(86) International application number: PCT/KR2022/018826
(87) International publication number: WO 2024/063206

(57) **Abstract**

An electronic device according to an embodiment disclosed herein includes a communication circuit configured to receive, from a server, information indicating whether evaluation for certificate issuance of a battery of an electric vehicle is possible, a processor configured to select a ready screen to be displayed between a first ready screen and a second ready screen, based on the information, and a display configured to display the selected ready screen.

## Description

### [TECHNICAL FIELD]

### CROSS-REFERENCE TO RELATED APPLICATION

This application claims priority to and the benefit of Korean Patent Application No. 10-2021-0118198 filed in the Korean Intellectual Property Office September 19, 2022, the entire contents of which are incorporated herein by reference.

### TECHNICAL FIELD

Embodiments disclosed herein relate to an electronic device that provides a user guide for battery evaluation, a server, and an operating method.

### [BACKGROUND ART]

As an environment problem and an energy resource problem have emerged, a hybrid vehicle, an electric vehicle, etc., among various types of vehicles are in the limelight as transportations of the future. The hybrid vehicle and the electric vehicle may use a battery pack including a plurality of secondary chargeable/dischargeable batteries as a main power source.

Batteries gradually deteriorate over time due to charging, discharging, and leaving from the time of shipment. Deterioration of the batteries appears in various forms, such as a decrease in maximum chargeable capacity, an increase in internal resistance, etc., and there are parameters capable of identifying the degree of deterioration of each of a plurality of battery cells connected in series in a battery pack.

Information related to a state of a battery associated with deterioration of the batter, etc., may be provided to a user through a display of a user terminal.

### [DISCLOSURE]

### [TECHNICAL PROBLEM]

Embodiments of the present disclosure aim to allow a user to easily access information related to a state of a battery.

Embodiments of the present disclosure aim to guide procedures for certification of a battery to the user.

Technical problems of the embodiments disclosed herein are not limited to the above-described technical problems, and other unmentioned technical problems would be clearly understood by one of ordinary skill in the art from the following description.

### [TECHNICAL SOLUTION]

An electronic device according to an embodiment disclosed herein includes a communication circuit configured to receive, from a server, information indicating whether evaluation for certificate issuance of a battery of an electric vehicle is possible, a processor configured to select a ready screen to be displayed between a first ready screen and a second ready screen, based on the information, and a display configured to display the selected ready screen.

The processor of the electronic device according to an embodiment disclosed herein may be further configured to select the first ready screen when the evaluation for certificate issuance is not possible, and select the second ready screen when the evaluation for certificate issuance is possible.

In the electronic device according to an embodiment disclosed herein, the information may include a state of charge (SoC) of the battery of the electric vehicle and information about whether the electric vehicle and a charging station are connected to each other or not, the first ready screen may guide connection between the electric vehicle and the charging station when the electric vehicle and the charging station are not connected to each other, and when the SoC exceeds a designated SoC, the first ready screen may guide that the evaluation is possible when the SoC is less than or equal to the designated SoC.

The communication circuit of the electronic device according to an embodiment disclosed herein may be further configured to transmit, to the server, a first message requesting the evaluation of the battery, when obtaining a user input requesting the evaluation of the battery during displaying of the second ready screen, and the display may be further configured to change the second ready screen into a progress screen when the first message is transmitted.

The communication circuit of the electronic device according to an embodiment disclosed herein may be further configured to receive, from the server, a second message indicating a result of the evaluation, after requesting the evaluation to the server, and the display may be further configured to change the progress screen into a result screen including the result of the evaluation when the second message is received.

An operating method of an electronic device according to an embodiment disclosed herein includes receiving, from a server, information indicating whether evaluation for certificate issuance of a battery of an electric vehicle is possible, selecting a ready screen to be displayed based on the information, between a first ready screen and a second ready screen, and displaying the selected ready screen.

According to an embodiment disclosed herein, the selecting of the ready screen may include selecting the first ready screen when the evaluation for certificate issuance is not possible and selecting the second ready screen when the evaluation for certificate issuance is possible.

The operating method of the electronic device according to an embodiment disclosed herein may further include transmitting, to the server, a first message requesting the evaluation of the battery, when obtaining a user input requesting the evaluation of the battery during displaying of the second ready screen and changing the second ready screen into a progress screen when the first message is transmitted to the server.

The operating method of the electronic device according to an embodiment disclosed herein may further include receiving, from the server, a second message indicating a result of the evaluation, after requesting the evaluation to the server and changing the progress screen into a result screen including the result of the evaluation when the second message is received.

A server according to an embodiment disclosed herein includes a processor configured to determine whether evaluation for certificate issuance of a battery of an electric vehicle is possible, based on a state of charge (SoC) of the battery of the electric vehicle and information about whether the electric vehicle and a charging station are connected to each other or not and a communication circuit configured to transmit, to an electronic device, information indicating whether the evaluation for certificate issuance of the battery of the electric vehicle is possible.

The processor of the server according to an embodiment disclosed herein may be further configured to determine that the evaluation for certificate issuance of the battery of the electric vehicle is not possible, when the electric vehicle and the charging station are not connected to each other or when the SoC exceeds a designated SoC and to determine that the evaluation for certificate issuance of the battery of the electric vehicle is possible, when the electric vehicle and the charging station are connected to each other and when the SoC is less than or equal to the designated SoC.

The communication circuit of the server according to an embodiment disclosed herein may be further configured to receive, from the electronic device, a first message requesting the evaluation of the battery, after transmitting, to the electronic device, information indicating that the evaluation is possible, and the processor may be further configured to perform the evaluation of the battery after receiving the first message.

The communication circuit of the server according to an embodiment disclosed herein may be further configured to receive, from the electronic device, a third message requesting certificate issuance of the battery, after transmitting a second message indicating a result of the evaluation, and the processor may be further configured to issue a certificate including the evaluation of the battery after receiving the third message.

### [ADVANTAGEOUS EFFECTS]

According to various embodiments disclosed herein, an electronic device, a server, and an operating method may provide information related to a state of a battery to a user.

According to various embodiments disclosed herein, the electronic device, the server, and the operating method may guide procedures for certification of the battery to the user.

The effects of the electronic device, the server, and the operating method according to the disclosure of the present document are not limited to the effects mentioned above, and other effects not mentioned will be clearly understood by those of ordinary skill in the art according to the disclosure of the present document.

### [DESCRIPTION OF DRAWINGS]

FIG. 1 illustrates a network environment according to an embodiment of the present disclosure.
FIG. 2A is a block diagram of a server according to an embodiment of the present disclosure.
FIG. 2B is a block diagram of a user terminal according to an embodiment of the present disclosure.
FIG. 3 illustrates a screen of an application executed in a user terminal, according to an embodiment of the present disclosure.
FIG. 4A illustrates a main screen of an application executed in a user terminal, according to an embodiment of the present disclosure.
FIG. 4B illustrates contents displayed on a drawer screen of an application executed in a user terminal, according to an embodiment of the present disclosure.
FIG. 4C illustrates contents displayed on a driving information screen of an application executed in a user terminal, according to an embodiment of the present disclosure.
FIG. 4D illustrates contents displayed on a battery care screen of an application executed in a user terminal, according to an embodiment of the present disclosure.
FIG. 4E illustrates contents displayed on a battery certificate screen of an application executed in a user terminal, according to an embodiment of the present disclosure.
FIG. 4F illustrates contents displayed on a nearby charging station screen of an application executed in a user terminal, according to an embodiment of the present disclosure.
FIG. 4G illustrates contents displayed on an electric vehicle (EV) life screen of an application executed in a user terminal, according to an embodiment of the present disclosure.
FIG. 4H illustrates contents displayed on a main screen of an application executed in a user terminal, according to an embodiment of the present disclosure.
FIG. 5 is a flowchart of operations for displaying screens related to battery evaluation in a user terminal, according to an embodiment of the present disclosure.
FIG. 6 illustrates screens displayed on a user terminal, according to an embodiment of the present disclosure.
FIG. 7 illustrates screens displayed on a user terminal, according to an embodiment of the present disclosure.

With regard to the description of the drawings, similar reference numerals may be used to refer to similar or related components.

### [MODE FOR INVENTION]

Hereinafter, embodiments of the present disclosure will be described with reference to the accompanying drawings. However, the description is not intended to limit the present disclosure to particular embodiments, and it should be construed as including various modifications, equivalents, and/or alternatives according to the embodiments of the present disclosure.

It should be appreciated that embodiments of the present document and the terms used therein are not intended to limit the technological features set forth herein to a particular embodiment and include various changes, equivalents, or replacements for a corresponding embodiment. With regard to the description of the drawings, similar reference numerals may be used to refer to similar or related elements. It is to be understood that a singular form of a noun corresponding to an item may include one or more of the things, unless the relevant context clearly indicates otherwise.

As used herein, each of such phrases as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Such terms as "1^{st}", "2^{nd}," "first", "second", "A", "B", "(a)", or "(b)" may be used to simply distinguish a corresponding component from another, and does not limit the components in other aspect (e.g., importance or order), unless mentioned otherwise.

Herein, it is to be understood that when an element (e.g., a first element) is referred to, with or without the term "operatively" or "communicatively", as "connected with", "coupled with", or "linked with", or "coupled to" or "connected to" to another element (e.g., a second element), it means that the element may be connected with the other element directly (e.g., wiredly or wirelessly), or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., compact disc read only memory (CD-ROM)), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the multiple entities may be separately disposed in different components. According to various embodiments disclosed herein, one or more of the above-described components may be omitted, or one or more other components may be added. Alternatively or additionally, a plurality of components (e.g., modules or programs) may be integrated into a single component. In such a case, according to various embodiments, the integrated component may still perform one or more functions of each of the plurality of components in the same or similar manner as they are performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

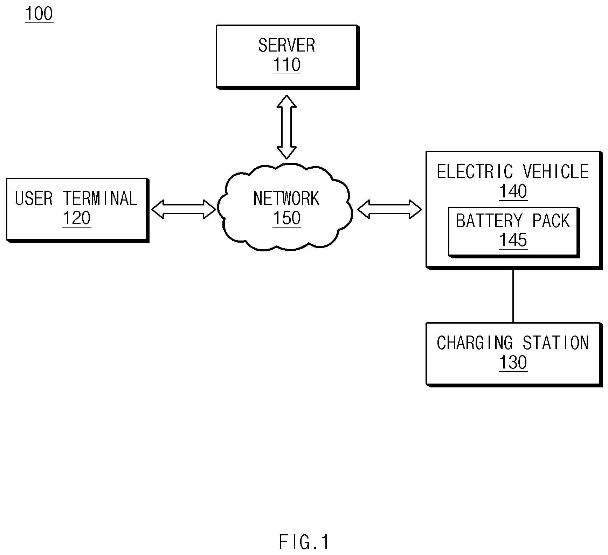

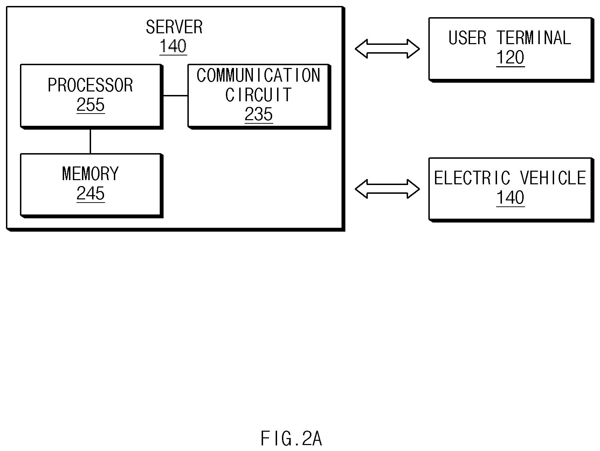

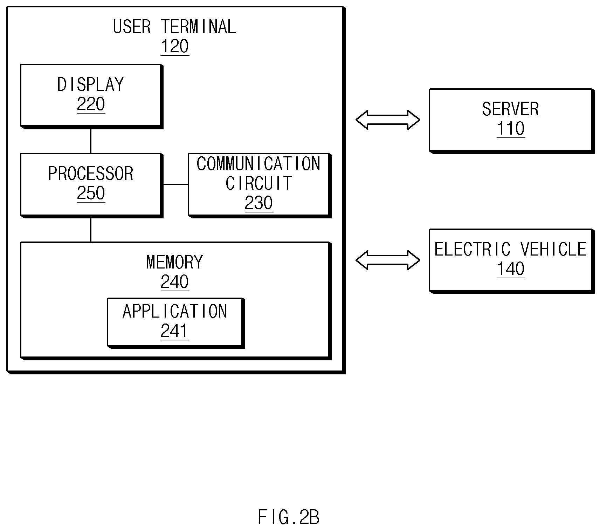

FIG. 1 illustrates a network environment 100 according to an embodiment of the present disclosure. FIG. 2A is a block diagram of a server 110 according to an embodiment of the present disclosure. FIG. 2B is a block diagram of a user terminal 120 according to an embodiment of the present disclosure.

Referring to FIG. 1, in the network environment 100, the server 110, a user terminal 120, a charging station 130, and/or an electric vehicle 140 may be connected to one another through a network 150. In an embodiment, the network 150 may be a network based on cellular communication, short-range wireless communication, and/or global navigation satellite system (GNSS) communication. In an embodiment, the network 150 may include a short-range communications network (e.g., Bluetooth, wireless fidelity (Wi-Fi), and/or infrared data association (IrDA)), and/or a long-range communication network (e.g., a legacy cellular network (e.g., a 2^{nd} Generation (2G) to a 4^{th} Generation (4G)), a 5^{th} Generation (5G) network, a next-generation network, the Internet, or a computer network (e.g., a local area network (LAN) or wide area network (WAN)). According to an embodiment, the charging station 130 and the electric vehicle 140 may be electrically connected to each other.

Referring to FIG. 2A, the server 110 may include a communication circuit 235, a memory 245, and a processor 255.

In an embodiment, the communication circuit 235 may transmit and receive data to and from the user terminal 120 and/or the electric vehicle 140 through the network 150. In an embodiment, the communication circuit 235 may transmit and receive data to and from the user terminal 120 and/or the electric vehicle 140 based on at least one radio access technology (RAT).

In an embodiment, the memory 245 may include a volatile and/or a nonvolatile memory. In an embodiment, the memory 245 may store data used by at least one component (e.g., the processor 255) of the server 110. For example, the data may include software (or an instruction related thereto), input data, or output data. In an embodiment, the instruction, when executed by the processor 255, may cause the server 110 to perform operations defined by the instruction.

In an embodiment, the processor 255 may execute software to control at least one other component (e.g., a hardware or software component) of the server 110 connected to the processor 255 and may process or compute various data.

Referring to FIG. 2B, the user terminal 120 may include a display 220, a communication circuit 230, a memory 240, and a processor 250. In an embodiment, the user terminal 120 may be implemented as a portable electronic device (e.g., a smartphone).

In an embodiment, the display 220 may visually provide information to the outside (e.g., a user) of the user terminal 120. In an embodiment, the display 220 may be implemented as any one of a liquid crystal display (LCD), a light-emitting diode (LED) display, or an organic light-emitting diode (OLED) display. In an embodiment, the display 220 may be formed as a touch screen that senses a touch and/or proximity touch (or hovering) input using a body part (e.g., a finger) of the user or an input device (e.g., a stylus pen). In an embodiment, the display 220 may include a touch sensor configured to sense a touch, or a pressure sensor configured to measure the intensity of force incurred by the touch.

In an embodiment, the communication circuit 230 may transmit and receive data to and from the server 110 and/or the electric vehicle 140 through the network 150. In an embodiment, the communication circuit 230 may transmit and receive data to and from the server 110 and/or the electric vehicle 140 based on at least one RAT.

In an embodiment, the memory 240 may include a volatile and/or a nonvolatile memory. In an embodiment, the memory 240 may store data used by at least one component (e.g., the processor 250) of the user terminal 120. For example, the data may include software (or an instruction related thereto), input data, or output data. In an embodiment, the instruction, when executed by the processor 250, may cause the user terminal 120 to perform operations defined by the instruction.

In an embodiment, the memory 240 may store an application 241 executable by the processor 250.

In an embodiment, the processor 250 may execute software to control at least one other component (e.g., a hardware or software component) of the user terminal 120 connected to the processor 250 and may process or compute various data.

In an embodiment, the processor 250 may execute the application 241. In an embodiment, the processor 250 may control the display 220 to output a screen (a graphic user interface (GUI)) showing an execution result of the application 241 through the display 220.

In an embodiment, the application 241 may support an information exchange function between the user terminal 120 and an external electronic device (e.g., the server 110 and/or the electric vehicle 140). In an embodiment, the information exchange function may include a notification relay function set to deliver designated information (e.g., a message or an alarm) to an external electronic device (e.g., the server 110 and/or the electric vehicle 140) or a device management function set to manage an external electronic device (e.g., the electric vehicle 140).

In an embodiment, the application 241 may generate a screen (or a GUI) showing an execution result of the application 241 by being executed by the processor 250. In an embodiment, the screen showing the execution result of the application 241 may include information for management of a battery pack 145 of the electric vehicle 140. In an embodiment, the screen showing the execution result of the application 241 may include information related to a user account of the user terminal 120.

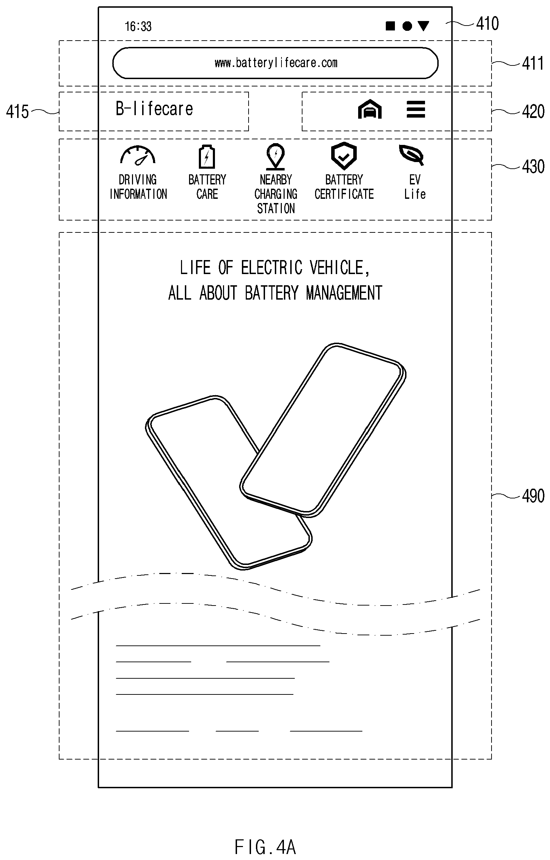

In an embodiment, the screen showing the execution result of the application 241 may include a main screen, a drawer screen, a driving information screen, a battery care screen, a battery certificate screen, a nearby charging station screen, and an electric vehicle (EV) life screen of the application 241. In an embodiment, the main screen, the drawer screen, the driving information screen, the battery care screen, the battery certificate screen, the nearby charging station screen, or the EV life screen of the application 241 may be switched to each other by a user input (e.g., a touch input, a press input). The screens will be described below with reference to FIGS. 4A to 4H.

In an embodiment, the charging station 130 may be a charging device installed to charge the battery pack 145 of the electric vehicle 140. In an embodiment, the charging station 130 may be installed in a parking lot, a gas station, a public institution, a building, an apartment, a mansion, a private house, etc.

In an embodiment, the charging station 130 may be capable of communicating with the electric vehicle 140 through wireless connection and/or wired connection with the electric vehicle 140.

In an embodiment, the charging station 130 may charge the battery pack 145 of the electric vehicle 140 through a charging port of the electric vehicle 140.

In an embodiment, the electric vehicle 140 may include an electric vehicle (EV), a hybrid EV (HEV), a plug-in HEV (PHEV), and/or a fuel cell EV (FCEV).

In an embodiment, the electric vehicle 140 and the charging station 130 may transmit and receive data to and from each other by using a wire (e.g., power line communication (PLC)).

In an embodiment, the electric vehicle 140 may include the battery pack 145. The battery pack 145 may be controlled using an in-vehicle network (IVN) technique. In an embodiment, the IVN technique may include a controller area network (CAN), a media oriented systems transport (MOST) network, a local interconnect network (LIN), and/or Ethernet.

In an embodiment, the battery pack 145 may supply power required for driving of the electric vehicle 140. In an embodiment, the battery pack 145 may be charged by power supplied from the charging station 130 through a charging port (not shown).

In an embodiment, the battery pack 145 may include a battery management system (BMS) that monitors a state of charge (SoC), a state of a battery (over-voltage, over-current, over-heat, etc.), and so forth, and prevents over-charge, over-discharge, etc. State information (e.g., an SoC of the battery pack 145 of the electric vehicle 140, a battery state, and information about whether the electric vehicle 140 and the charging station 130) are connected to each other or not) obtained by the BMS (not shown) may be delivered to the server 110 through the electric vehicle 140.

Hereinbelow, a description will be made of a process in which the user terminal 120 according to an embodiment of the present disclosure requests evaluation of the battery pack 145 and obtains a certificate for the battery pack 145, through the application 241.

In an embodiment, the user terminal 120 may display an initial screen (or a main screen) of the application 241 on the display 220 by executing the application 241. The initial screen of the application 241 may include a user account of the application 241 and information about the electric vehicle 140 and/or the battery pack 145 related to the user account. In an embodiment, the user account and the information about the electric vehicle 140 and/or the battery pack 145 related to the user account may be information received from the server 110. **In** an embodiment, information of the user account may include user's personal information (e.g., unchangeable items (e.g., a name, an e-mail) or changeable items (e.g., a phone number, an address)). **In** an embodiment, the information about the electric vehicle 140 may include information about an owner, a license plate number, a vehicle identification number, a manufacturer, and a vehicle model. **In an** embodiment, the information about the battery pack 145 may include the stat of charge (SoC) or a fuel economy of the battery pack 145.

**In** an embodiment, the user terminal 120 may obtain a user input (e.g., a touch input to a battery certificate icon) to request switch to a battery certificate screen through the application 241. **In** an embodiment, the user terminal 120 may switch a screen displayed through the application 241 into the battery certificate screen, based on the user input to request switch to the battery certificate screen. **In** an embodiment, contents for certificate issuance, a certificate list, and certificate details view may be included in the battery certificate screen.

**In** an embodiment, the user terminal 120 may obtain a user input (e.g., a touch input to a certificate issuance icon) to select contents for certificate issuance through the battery certificate screen of the application 241. **In** an embodiment, the user terminal 120 may switch a screen displayed through the application 241 into the certificate issuance screen, based on the user input selecting the contents for certificate issuance. In an embodiment, the user terminal 120 may identify information related to certificate issuance based on the user input selecting the contents for certificate issuance, and switch the screen displayed through the application 241 into the certificate issuance screen, based on the identified information related to certificate issuance. **In** an embodiment, the certificate issuance screen may be a screen for guiding issuance of the battery certificate.

In an embodiment, when an on-board diagnostics (OBD) device is not mounted on the electric vehicle 140, the certificate issuance screen may include contents for suggesting mounting of the OBD to the user. In an embodiment, when the user has no record of being issued a certificate for the electric vehicle 140 even though the OBD device is mounted on the electric vehicle 140, the certificate issuance screen may include a phrase introducing a battery certificate function and benefits and contents showing an image. In an embodiment, when the user has a record of being issued the certificate for the electric vehicle 140, the certificate issuance screen may include contents for suggesting additional issuance of the battery certificate. In an embodiment, there is an error in a certificate the user is issued, the certificate issuance screen may include contents for suggesting re-execution of a certification procedure with respect to the battery pack 145.

In an embodiment, the user terminal 120 may obtain a user input (e.g., a touch input to an evaluation certification icon) to request switch to a ready screen for evaluation of the battery pack 145 through the certificate issuance screen of the application 241.

In an embodiment, the user terminal 120 may request, to the server 110, information indicating whether evaluation for certificate issuance of the battery pack 145 of the electric vehicle 140 is possible, by using the communication circuit 230 based on the user input. The processor 255 of the server 110 may determine whether evaluation for certificate issuance of the battery pack 145 is possible, based on the request of the user terminal 120. For example, the processor 255 of the server 110 may determine that evaluation of the battery pack 145 is possible, when the electric vehicle 140 and the charging station 130 are connected to each other and the SoC of the battery pack 145 is less than or equal to a designated SoC (e.g., 30 %). However, the processor 255 of the server 110 may determine that evaluation of the battery pack 145 is not possible, when the electric vehicle 140 and the charging station 130 are not connected to each other or the SoC exceeds the designated SoC (e.g., 30 %). Thereafter, the communication circuit 235 of the server 110 may transmit the information indicating whether evaluation for certificate issuance of the battery pack 145 of the electric vehicle 140 is possible to the user terminal 120.

In an embodiment, the user terminal 120 may receive, from the server 110, the information indicating whether evaluation for certificate issuance of the battery pack 145 of the electric vehicle 140 is possible, by using the communication circuit 230. In an embodiment, the information indicating whether evaluation is possible may further include the SoC of the battery pack 145 of the electric vehicle 140 and information about whether the electric vehicle 140 and the charging station 130 are connected to each other.

In an embodiment, the user terminal 120 may select a ready screen to be displayed between a first ready screen and a second ready screen, based on the information indicating whether evaluation is possible. The first ready screen may guide connection between the electric vehicle and the charging station when the electric vehicle and the charging station are not connected to each other, and in case of the SoC exceeding the designated SoC, the first ready screen may guide that evaluation is possible when the SoC is less than or equal to the designated SoC. On the first ready screen, an input button to proceed with evaluation of the battery pack 145 may be deactivated. On the second ready screen, the input button to proceed with evaluation of the battery pack 145 may be activated.

In an embodiment, the user terminal 120 may select the first ready screen when evaluation for certificate issuance is not possible, and select the second ready screen when evaluation for certificate issuance is possible.

In an embodiment, the user terminal 120 may display a ready screen selected through the display 220.

In an embodiment, the user terminal 120 may obtain a user input to the activated input button while the second ready screen is being displayed. Herein, the user input may be understood as an input to request evaluation of the battery pack 145.

In an embodiment, the user terminal 120 may transmit a first message for requesting evaluation of the battery pack 145 to the server 110 by using the communication circuit 230 upon obtaining the user input to the activated input button. In an embodiment, the user terminal 120 may change the second ready screen into a progress screen upon transmitting the first message. Thus, the display 220 may display the progress screen.

The communication circuit 235 of the server 110 may receive the first message from the user terminal 120. The processor 255 of the server 110 may perform evaluation of the battery pack 145 after receiving the first message. In an embodiment, evaluation of the battery pack 145 may be performed based on information (e.g., an open circuit voltage (OCV), an SoC, a state of health (SoH)) obtained during charge of the battery pack 145 of the electric vehicle 140. In an embodiment, evaluation of the battery pack 145 may be performed based on service life of the battery pack 145. In an embodiment, evaluation of the battery pack 145 may be performed by comparing information of other battery packs of the same kind as the battery pack 145 with the information obtained during charge of the battery pack 145.

The communication circuit 235 of the server 110 may transmit a second message indicating a result of evaluation. The communication circuit 230 of the user terminal 120 may receive the second message indicating the result of evaluation from the server 110.

The user terminal 120 may change the progress screen into a result screen upon receiving the second message. Thus, the display 220 may display the result screen.

In an embodiment, the user terminal 120 may obtain a user input to the activated input button while the result screen is being displayed. Herein, the user input may be understood as an input to request issuance of a certificate of the battery pack 145.

In an embodiment, the user terminal 120 may transmit the second message for requesting issuance of the certificate of the battery pack 145 to the server 110 by using the communication circuit 230 upon obtaining the user input to the activated input button.

The communication circuit 235 of the server 110 may receive a third message requesting issuance of the certificate of the battery pack 145 from the user terminal 120. The processor 255 of the server 110 may issue a certificate including evaluation of the battery pack 145 after receiving the third message.

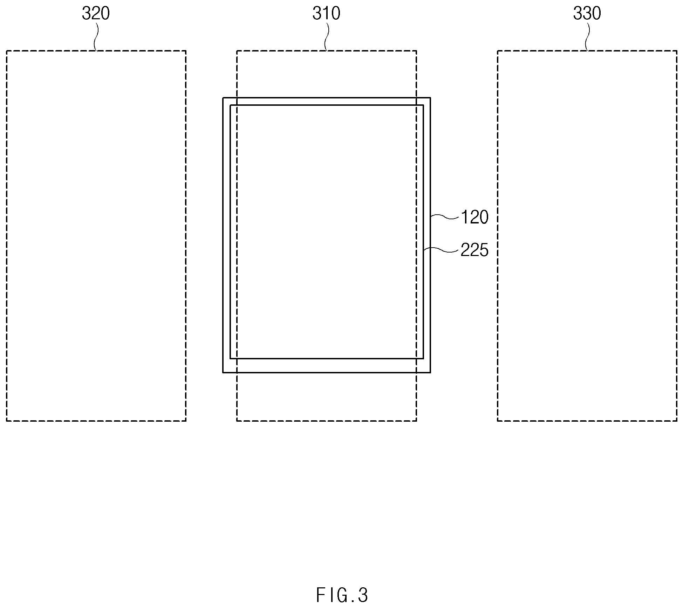

FIG. 3 shows screens 310, 320, and 330 of the application 241 executed in the user terminal 120, according to an embodiment of the present disclosure.

Referring to FIG. 3, the user terminal 120 may include a display region 225. The display region 225 may be a region of the display 220 exposed to the user.

In an embodiment, the user terminal 120 may generate screens 310, 320, and 330 showing execution results of the application 241 by executing the application 241. In an embodiment, the user terminal 120 may output at least a part of the screens 310, 320, and 330 through the display region 225. In an embodiment, the user terminal 120 may switch among the screens 310, 320, and 330 based on a user input (e.g., a press input). In an embodiment, the user terminal 120 may scroll the screen 310 being displayed, based on a user input (e.g., a drag input).

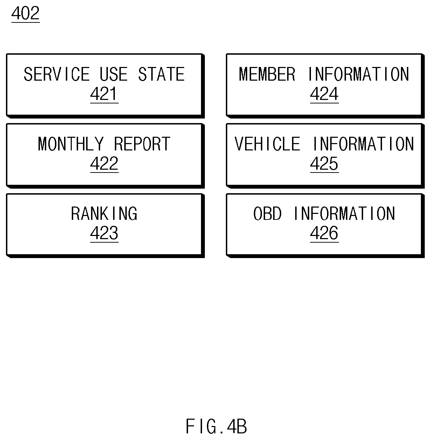

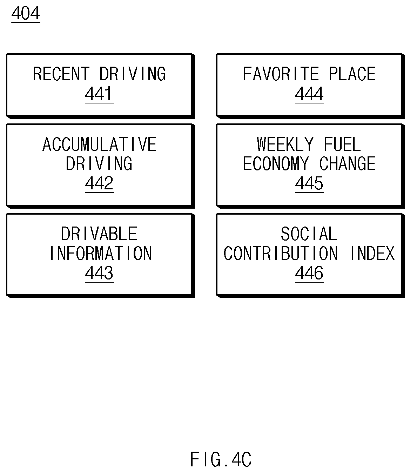

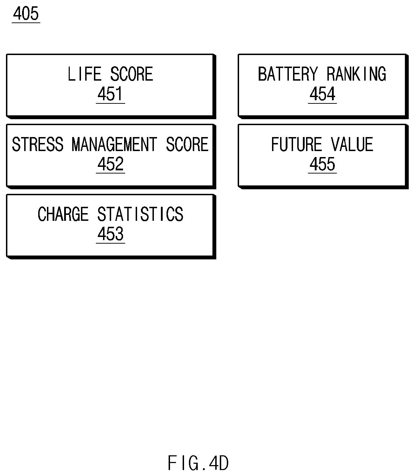

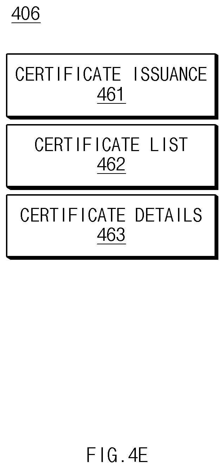

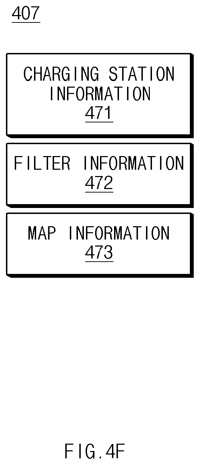

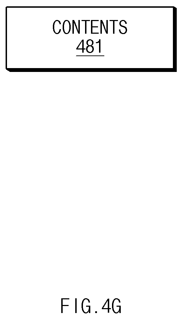

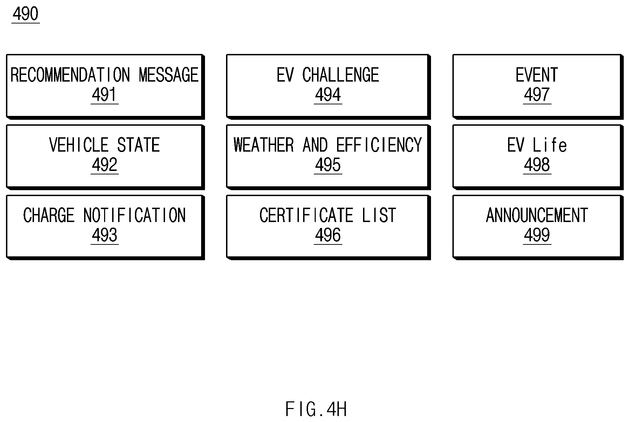

FIG. 4A shows a main screen 410 of the application 241 executed in the user terminal 120, according to an embodiment of the present disclosure. FIG. 4B shows contents 402 displayed on a drawer screen of the application 241 executed in the user terminal 120, according to an embodiment of the present disclosure. FIG. 4C shows contents 404 displayed on a driving information screen of the application 241 executed in the user terminal 120, according to an embodiment of the present disclosure. FIG. 4D shows contents 405 displayed on a battery care screen of the application 241 executed in the user terminal 120, according to an embodiment of the present disclosure. FIG. 4E shows contents 406 displayed on a battery certificate screen of the application 241 executed in the user terminal 120, according to an embodiment of the present disclosure. FIG. 4F shows contents 407 displayed on a nearby charging station screen of the application 241 executed in the user terminal 120, according to an embodiment of the present disclosure. FIG. 4G shows contents 481 displayed on an EV life screen of the application 241 executed in the user terminal 120, according to an embodiment of the present disclosure. FIG. 4H shows contents 409 displayed on a main screen of the application 241 executed in the user terminal 120, according to an embodiment of the present disclosure.

Referring to FIG. 4A, the main screen 410 may be an initial screen of the application 241. The main screen 410 may include at least one regions 411, 415, 420, 430, and 490.

The region 411 may be a region indicating an address (e.g., a uniform resource identifier (URI)). The region 415 may be a region indicating a service name. The user terminal 120 may display the main screen 410 in response to a user input selecting an image object indicating the service name of the region 415.

The region 420 may include an image object (or an icon) indicating a home button and an image object (or an icon) indicating a drawer. The user terminal 120 may display the main screen 410 in response to a user input (e.g., a press input) to select an image object (or an icon) indicating the home button of the region 420. The user terminal 120 may display the drawer screen in response to a user input selecting an image object indicating the drawer of the region 420. Referring to FIG. 4B, the contents 402 indicating a service usage state 421, a monthly report 422, a ranking 423, member information 424, vehicle information 425, and on-board diagnostics (OBD) information 426 may be included in the drawer screen.

The service usage state 421 may be contents displayed by activation of a region indicating a service being used (e.g., ordinary battery diagnosis or a battery certificate) according to the service. The monthly report 422 may be contents where a region for comparing the number of fast charge times with the number of slow charge times, a region showing development of changes in a driving distance, a region showing development of changes in a fuel economy, and a region showing development of changes in a fuel saving cost are displayed. The ranking 423 may be contents showing a ranking for each of all users, a ranking for the same vehicle type, and a ranking for the same year model based on a fuel economy or a battery score of the battery pack 145 of the electric vehicle 140 on a monthly basis. The member information 424 may be contents showing user's personal information (e.g., unchangeable items (e.g., a name, an e-mail) or changeable items (e.g., a phone number, an address)). The vehicle information 425 may be contents showing information about an owner, a license plate number, a vehicle identification number, a manufacturer, and a vehicle model. The OBD information 426 may be contents showing mounted vehicle information related to the OBD device, and information about a service used, a usage period, or a serial number.

The region 430 may include one or more navigation icons. The user terminal 120 may display a screen corresponding to a navigation icon selected in response to a user input selecting any one of the one or more navigation icons. In an embodiment, the one or more navigation icons may include a driving information icon, a battery care icon, a battery certificate icon, a nearby charging station icon, and an EV life icon.

In an embodiment, the user terminal 120 may display a driving information screen in response to an input selecting the driving information icon of the region 430. Referring to FIG. 4C, the driving information screen may include contents 404 showing recent driving 441, accumulative driving 442, drivable information 443, a favorite place 444, a weekly fuel economy change 445, and a social contribution index 446.

The recent driving 441 may be contents for showing a driving distance, a driving time, and a fuel economy, and increased or decreased driving distance, driving time, and fuel economy from immediately previous driving. The accumulative driving 442 may be contents for showing an accumulative driving distance, an accumulative driving time, and an accumulative average fuel economy. The drivable information 443 may be contents for showing a total drivable distance with respect to the current charge amount and fuel economy of the battery pack 145. The favorite place 444 may be contents for showing a distance to a designated number (e.g., 3) of points (e.g., home, a company, favorites) at the current position. The weekly fuel economy change 445 may be contents for showing a fuel economy change and an average fuel economy corresponding to a designated period (e.g., 7 days). The social contribution index 446 may be contents for showing a carbon emission saving and a fuel saving cost.

In an embodiment, the user terminal 120 may display the battery care screen in response to an input selecting the battery care icon of the region 430. Referring to FIG. 4D, the battery care screen may include contents 405 showing a life score 451, a stress management score 452, charge statistics 453, a battery ranking 454, and a future value 455.

The life score 451 may be contents for showing a life score of the battery pack 145 and a percentile rank according to the life score. The life score may be quantified based on a state of health (SoH). The stress management score 452 may be contents for showing a stress management score of the battery pack 145 and a percentile rank according to the stress management score. The stress management score may be quantified based on driving habits and charge habits of the user for the electric vehicle 140. The charge statistics 453 may be contents for showing a ratio of slow charge to fast charge. The battery ranking 454 may be contents for showing a rank among users with respect to a life score and a stress management score. The future value 455 may be contents for showing a battery life among the same vehicles as the electric vehicle 140 with respect to the life score and the stress management score.

In an embodiment, the user terminal 120 may display the battery certificate screen in response to an input selecting the battery certificate icon of the region 430. Referring to FIG. 4E, the battery certificate screen may include contents 406 showing certificate issuance 461, a certificate list 462, and certificate details 463.

In an embodiment, the certificate issuance 461 may be contents for guiding issuance of the battery certificate. In an embodiment, when the OBD device is not mounted on the electric vehicle 140, the certificate issuance 461 may include contents for suggesting mounting of the OBD to the user. In an embodiment, when the user has no record of being issued a certificate for the electric vehicle 140 even though the OBD device is mounted on the electric vehicle 140, the certificate issuance 461 may include a phrase introducing a battery certificate function and benefits and contents showing an image. In an embodiment, when the user has a record of being issued the certificate for the electric vehicle 140, the certificate issuance 461 may include contents suggesting additional issuance of the battery certificate. In an embodiment, there is an error in a certificate the user is issued, the certificate issuance 461 may include contents suggesting re-execution of a certification procedure with respect to the battery pack 145.

The certificate list 462 may include contents showing information related to issued certificates (e.g., a certificate type, an issuance date, an expiry date, an issuance number, a vehicle name, a license plate number) in the form of a card. The certificate details 463 may include contents showing a ratio of a chargeable energy of the battery pack 145 to a chargeable energy at the time of initial shipment and a drivable distance at the time of full charge of the battery pack 145.

In an embodiment, the user terminal 120 may display the nearby charging station screen in response to an input selecting the nearby charging station icon of the region 430. Referring to FIG. 4F, the nearby charging station screen may include contents 407 showing charging station information 471, filter information 472, and map information 473.

The charging station information 471 may be contents for showing a place name, a chargeable state for each charger (e.g., chargeable or non-chargeable), and the number of chargeable chargers for each charge type. The filter information 472 may be contents for filtering a charging station for each charge type. The map information 473 may be contents providing an interface for pathfinding.

In an embodiment, the user terminal 120 may display the EV life screen in response to an input selecting the EV life icon of the region 430. Referring to FIG. 4G, the EV life screen may include contents 481 related to the EV life.

In an embodiment, the region 490 may be a region where contents of the main screen 410 are displayed. The region 490 may be scrolled based on a user input. A screen displayed on the region 490 may include contents 409 showing a recommendation message 491, a vehicle state 492, a charge notification 493, an EV challenge 494, weather and efficiency 495, a certificate list 496, an event 497, an EV life 498, and an announcement 499.

The recommendation message 491 may be contents for providing a tip message corresponding to a current state of the electric vehicle 140. The vehicle state 492 may be contents for showing driving, charge, and parking of the electric vehicle 140. The charge notification 493 may be contents for setting a maximum charge amount of the battery pack 145 of the electric vehicle 140 and a notification when the maximum charge amount is reached. The EV challenge 494 may be contents for showing the number of achieved challenges and a badge indicating the achieved challenge. The weather and efficiency 495 may be contents for showing battery efficiency according to the weather, and weather and temperature for a specified period. The certificate list 496 may be contents for showing the number of owned certificates and an icon for moving to the battery certificate screen. The event 497 may be contents for showing ongoing and ended events. The EV life 498 may be contents for showing notices. The announcement 499 may be contents for showing a posted announcement.

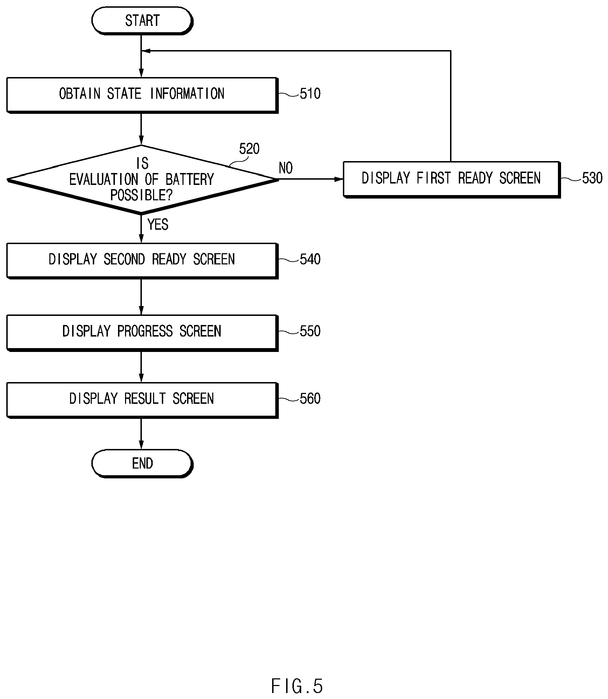

FIG. 5 is a flowchart of operations for displaying screens (GUI) related to battery evaluation in the user terminal 120, according to an embodiment of the present disclosure.

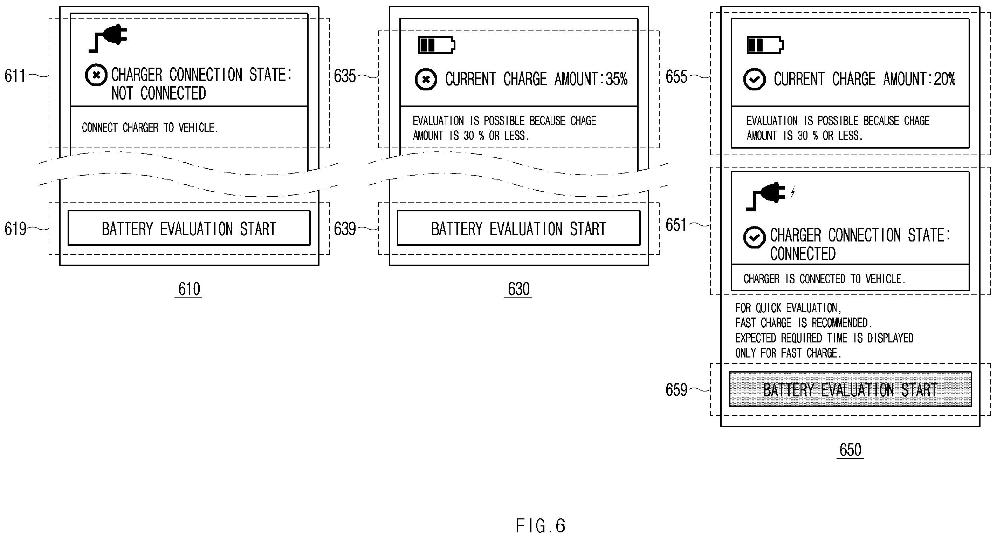

FIG. 6 shows screens 610, 630, and 650 displayed in the user terminal 120. The operations of FIG. 5 may be performed during execution of the application 241 in the user terminal 120.

**In** operation 510, the user terminal 120 may obtain state information related to battery evaluation. **In** an embodiment, the state information may indicate whether evaluation for certificate issuance of the battery pack 145 of the electric vehicle 140 is possible. **In** an embodiment, the state information may include the SoC of the battery pack 145 of the electric vehicle 140 and information about whether the electric vehicle 140 and the charging station 130 are connected to each other.

**In** operation 520, the user terminal 120 may determine whether battery evaluation is possible. **In** an embodiment, the user terminal 120 may determine whether battery evaluation of the battery pack 145 is possible, based on the state information.

In an embodiment, when determining that battery evaluation is not possible (No) in operation 520, the user terminal 120 may perform operation 530. In an embodiment, when determining that battery evaluation is possible (Yes) in operation 520, the user terminal 120 may perform operation 540.

In operation 530, the user terminal 120 may display the first ready screen. The first ready screen may guide connection between the electric vehicle and the charging station when the electric vehicle and the charging station are not connected to each other, and in case of the SoC exceeding the designated SoC, the first ready screen may guide that evaluation is possible when the SoC is less than or equal to the designated SoC. On the first ready screen, an input button to proceed with evaluation of the battery pack 145 may be deactivated.

Referring to FIG. 6, when the electric vehicle 140 and the charging station 130 are not connected to each other, the first ready screen may include a UI element 610. The UI element 610 may include a region 611 guiding the user that evaluation for certificate issuance is not possible. In the UI element 610, an input button 619 enabling evaluation for certificate issuance of the battery is in a deactivated state. The region 611 may include an icon and an announcement (e.g., "Connect Charger to Vehicle") guiding the user that evaluation for certificate issuance is not possible. The announcement may guide connection between the electric vehicle 140 and the charging station 130.

In an embodiment, when the SoC of the battery pack 145 is less than or equal to a designated SoC (e.g., 30 %), the first ready screen may include a UI element 630. The UI element 630 may include a region 635 guiding the user that evaluation for certificate issuance is not possible. In the UI element 630, an input button 639 enabling evaluation for certificate issuance of the battery is in the deactivated state. The region 635 may include an icon and an announcement (e.g., "Evaluation is Possible for Charge Amount of 30 % or Less") guiding the user that evaluation for certificate issuance is not possible. The announcement may guide that the SoC of the battery pack 145 of the electric vehicle 140 needs to be less than or equal to the designated SoC (e.g., 30 %).

In operation 540, the user terminal 120 may display the second ready screen. In an embodiment, the second ready screen may include an input button, which enables evaluation for certificate issuance of the battery, in an activated state. On the second ready screen, the input button to proceed with evaluation of the battery pack 145 may be activated.

Referring to FIG. 6, the second ready screen may include a UI screen 650. The UI element 650 may include regions 651 and 655 guiding the user that evaluation for certificate issuance is possible. In the UI element 650, an input button 659 enabling evaluation for certificate issuance of the battery is in the activated state. The UI element 650 may include an announcement (e.g., "Expected Required Time is Displayed for Only Fast Charge") guiding that an expected required time may be provided in fast charge.

In an embodiment, the user terminal 120 may determine whether battery evaluation is requested. In an embodiment, the user terminal 120 may determine that battery evaluation is requested, when a user input to the input button 659 is applied through the second ready screen.

In operation 550, the user terminal 120 may display the progress screen. In an embodiment, when obtaining an input to the input button 659 through the second ready screen, the user terminal 120 may request evaluation of the battery to the server 110 and then display the progress screen showing that evaluation of the battery is in progress. In an embodiment, the progress screen may include information about a time required for evaluation when the battery is being charged fast.

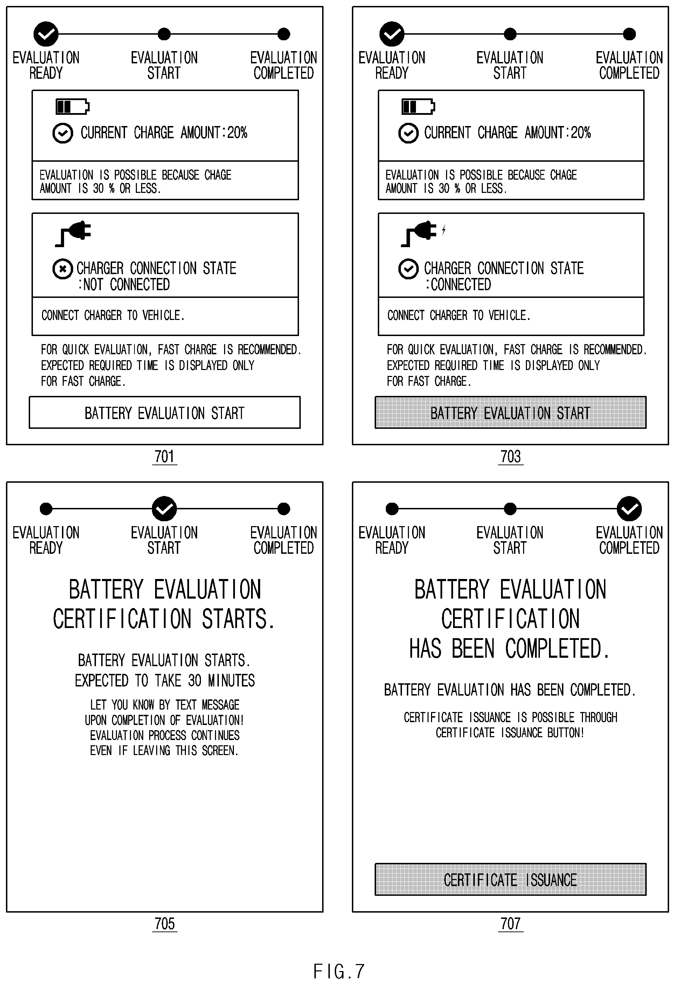

In operation 560, the user terminal 120 may display a result screen. In an embodiment, upon receiving a message indicating that evaluation is completed from the server 110 after requesting evaluation to the server 110, the user terminal 120 may display the result screen. Hereinbelow, the result screen will be described with reference to FIG. 7. In an embodiment, the result screen may include another input button, which indicates that evaluation for certificate issuance of the battery is possible, in the activated state.

FIG. 7 shows screens 701, 703, 705, and 707 displayed in the user terminal 120, according to an embodiment of the present disclosure.

Referring to FIG. 7, the screen 701 may show the first ready screen. The screen 701 may include an announcement guiding connection between the electric vehicle 140 and the charging station 130. In the screen 701, an input button (e.g., battery evaluation start) enabling evaluation for certificate issuance of the battery is in a deactivated state. The screen 701 may show that the current progress state is a state where evaluation is ready.

The screen 703 may show the second ready screen. In the screen 703, an input button (e.g., battery evaluation start) enabling evaluation for certificate issuance of the battery is in the activated state. The screen 703 may show that the current progress state is a state where evaluation is ready.

The screen 705 may show the progress screen. In fast charge, the screen 705 may include a region guiding an expected required time. The screen 705 may show that the current progress state is a state where evaluation has started.

The screen 707 may show the result screen. In the screen 707, an input button (e.g., battery evaluation start) enabling evaluation for certificate issuance of the battery is in the activated state. The screen 707 may show that the current progress state is a state where evaluation has been completed.

## Claims

1. An electronic device comprising:
a communication circuit configured to receive, from a server, information indicating whether evaluation for certificate issuance of a battery of an electric vehicle is possible;
a processor configured to select a ready screen to be displayed between a first ready screen and a second ready screen, based on the information; and
a display configured to display the selected ready screen.

2. The electronic device of claim 1, wherein the processor is further configured to:
select the first ready screen when the evaluation for certificate issuance is not possible; and
select the second ready screen when the evaluation for certificate issuance is possible.

3. The electronic device of claim 2, wherein the information comprises a state of charge (SoC) of the battery of the electric vehicle and information about whether the electric vehicle and a charging station are connected to each other or not,
the first ready screen guides connection between the electric vehicle and the charging station when the electric vehicle and the charging station are not connected to each other, and
when the SoC exceeds a designated SoC, the first ready screen guides that the evaluation is possible when the SoC is less than or equal to the designated SoC.

4. The electronic device of claim 1, wherein the communication circuit is further configured to transmit, to the server, a first message requesting the evaluation of the battery, when obtaining a user input requesting the evaluation of the battery during displaying of the second ready screen, and
the display is further configured to change the second ready screen into a progress screen when the first message is transmitted.

5. The electronic device of claim 4, wherein the communication circuit is further configured to receive, from the server, a second message indicating a result of the evaluation, after requesting the evaluation to the server, and
the display is further configured to change the progress screen into a result screen comprising the result of the evaluation when the second message is received.

6. An operating method of an electronic device, the operating method comprising:
receiving, from a server, information indicating whether evaluation for certificate issuance of a battery of an electric vehicle is possible;
selecting a ready screen to be displayed based on the information, between a first ready screen and a second ready screen; and
displaying the selected ready screen.

7. The operating of claim 6, wherein the selecting of the ready screen comprises:
selecting the first ready screen when the evaluation for certificate issuance is not possible; and
selecting the second ready screen when the evaluation for certificate issuance is possible.

8. The operating method of claim 7, wherein the information comprises a state of charge (SoC) of the battery of the electric vehicle and information about whether the electric vehicle and a charging station are connected to each other or not,
the first ready screen guides connection between the electric vehicle and the charging station when the electric vehicle and the charging station are not connected to each other, and
when the SoC exceeds a designated SoC, the first ready screen guides that the evaluation is possible when the SoC is less than or equal to the designated SoC.

9. The operating method of claim 6, further comprising:
transmitting, to the server, a first message requesting the evaluation of the battery, when obtaining a user input requesting the evaluation of the battery during displaying of the second ready screen; and
changing the second ready screen into a progress screen when the first message is transmitted to the server.

10. The operating method of claim 9, further comprising:
receiving, from the server, a second message indicating a result of the evaluation, after requesting the evaluation to the server; and
changing the progress screen into a result screen comprising the result of the evaluation when the second message is received.

11. A server comprising:
a processor configured to determine whether evaluation for certificate issuance of a battery of an electric vehicle is possible, based on a state of charge (SoC) of the battery of the electric vehicle and information about whether the electric vehicle and a charging station are connected to each other or not; and
a communication circuit configured to transmit, to an electronic device, information indicating whether the evaluation for certificate issuance of the battery of the electric vehicle is possible.

12. The server of claim 11, wherein the processor is further configured to:
determine that the evaluation for certificate issuance of the battery of the electric vehicle is not possible, when the electric vehicle and the charging station are not connected to each other or when the SoC exceeds a designated SoC; and
determine that the evaluation for certificate issuance of the battery of the electric vehicle is possible, when the electric vehicle and the charging station are connected to each other and when the SoC is less than or equal to the designated SoC.

13. The server of claim 11, wherein the communication circuit is further configured to receive, from the electronic device, a first message requesting the evaluation of the battery, after transmitting, to the electronic device, information indicating that the evaluation is possible, and
the processor is further configured to perform the evaluation of the battery after receiving the first message.

14. The server of claim 13, wherein the communication circuit is further configured to receive, from the electronic device, a third message requesting certificate issuance of the battery, after transmitting a second message indicating a result of the evaluation, and
the processor is further configured to issue a certificate comprising the evaluation of the battery after receiving the third message.
